# EUROPEAN PATENT SPECIFICATION

(11) **EP 4 250 466 B1**
(45) Date of publication and mention of the grant of the patent: **27.08.2025**
(21) Application number: 22842340.6
(22) Date of filing: 01.07.2022
(51) Int. Cl.: H01M 50/538, H01M 10/04, B23K 31/12, G01N 27/02, G01R 31/389, G01R 31/71, H01M 10/42, H01M 50/536, B23K 101/38

(54) **METHOD FOR INSPECTING STATE OF WELDS IN BATTERY**
VERFAHREN ZUR PRÜFUNG DES ZUSTANDES VON SCHWEISSNÄHTEN IN EINER BATTERIE
PROCÉDÉ D'INSPECTION DE L'ÉTAT DE SOUDURES DANS UNE BATTERIE

(30) Priority: 13.07.2021 KR 20210091698
(43) Date of publication of application: 27.09.2023
(73) Proprietor: LG Energy Solution, Ltd., Seoul 07335 (KR)
(72) Inventor: LEE, Jung Hoon, Daejeon 34122 (KR); JUNG, Su Taek, Daejeon 34122 (KR)
(74) Representative: Goddar, Heinz J.
(86) International application number: PCT/KR2022/009488
(87) International publication number: WO 2023/287078

(56) References cited:
- CN-A- 111 693 573
- DE-A1- 102019 212 028
- DE-A1- 102020 110 063
- KR-A- 20070 107 921
- KR-A- 20190 053 014
- KR-B1- 101 889 592
- US-A1- 2009 096 459
- US-A1- 2015 372 317
- US-A1- 2020 300 920
- US-A1- 2021 132 154
- US-B2- 10 274 448

## Description

### Technical Field

This application claims the benefit of priority based on Korean Patent Application No. 10-2021-0091698 filed on July 13, 2021.

The present disclosure relates to a method of inspecting a welding state of a battery, and to a method of inspecting a welding state of a battery which is capable of quickly and non-destructively inspecting states of electrodes of a battery.

### Background Art

In general, a current collector to which an active material is applied and an electrode tab for electrical connection to external electrical devices are connected together both physically and electrically in a battery by welding the current collector and the electrode tab. In the case of a defective welding state, the battery's operating efficiency is reduced, and depending on the situation, the defective welding state may result in damages to the battery. Therefore, it is crucial to accurately determine the welding state.

For a cylindrical battery, welds exist between the current collector and the electrode tab as well as between the electrode tab and the can. In order to inspect the welding states of these welds, a destructive inspection method of manually sampling welding regions has been performed.

Therefore, there existed a problem with the conventional method such as lots on hold when an issue with a welding state occurred.

In order to solve this problem, there is a need for a new inspection method which is capable of in-line total inspection. The prior art US 2020/300920 A1 discloses an impedance measurement system and an impedance measurement device (IMD) for analysis of batteries or other energy storage cells, e.g., for hybrid or electric vehicles, which involves exciting device under test (DUT) with multispectral excitation signal while DUT is under dynamic loading. The IMD is used in a variety of different environments and with different battery types such that the health of the battery may be monitored in-situ. As an example, the impedance measurement system may be incorporated within an automobile or other vehicle with batteries that include one or more energy storage cells or fuel cells. It is also contemplated that embodiments of the disclosure may be employed in applications related to analysis of weld junctures.

### Disclosure of the Invention

### Technical Goals

The present disclosure relates to a method of inspecting a welding state of a battery, and it is an object of the present disclosure to provide a method of inspecting a welding state of a battery, which is capable of quickly and non-destructively inspecting states of electrodes of the battery.

Technical objects to be achieved by the present disclosure are not limited to the technical problems as mentioned above, and other technical objects not mentioned will be clearly understood from the description below by those of ordinary skill in the art to which the present disclosure pertains.

### Technical Solutions

A method of inspecting a welding state of a battery of the present disclosure includes:
a first impedance measuring step of measuring a first impedance by applying an AC current or an AC voltage in a set frequency band before an electrolyte is injected into the battery; a first Cole-Cole plot creating step of creating a first Cole-Cole plot based on the first impedance; and a first determining step of determining the welding state of the battery based on an x-intercept value on the first Cole-Cole plot.

### Advantageous Effects

According to a method of inspecting a welding state of a battery of the present disclosure, it is possible to perform in-line total inspection, thereby improving the quality of battery production and removing defective batteries in advance.

According to a method of inspecting a welding state of a battery of the present disclosure, it is possible to identify welding qualities within a short time period.

According to a method of inspecting a welding state of a battery of the present disclosure, it is possible to determine the welding state of the battery simply by measuring the impedance between an anode and a cathode of the battery within a short time period without destructing the battery during manufacture of the battery. As such, the method of inspecting a welding state of a battery of the present disclosure may be adopted in the battery production line, thereby allowing for in-line total inspection of the batteries produced.

According to a method of inspecting a welding state of a battery of the present disclosure, it is possible to inspect a welding state of a battery before an electrolyte is injected into the battery, thereby allowing for inspection of the welding state of the battery regardless of the injection state of the electrolyte.

### Brief Description of Drawings

FIG. 1 is a block diagram illustrating a method of inspecting a welding state of a battery of the present disclosure.
FIG. 2 is an equivalent circuit diagram illustrating a battery in a first impedance measuring step.
FIG. 3 is a graph illustrating a first Cole-Cole plot.
FIG. 4 is a block diagram illustrating another example embodiment of the method of inspecting a welding state of a battery of the present disclosure.
FIG. 5 is an equivalent circuit diagram illustrating a battery in a second impedance measuring step.
FIG. 6 is a graph illustrating a second Cole-Cole plot.
FIG. 7 is a conceptual diagram illustrating a 4-wire AC impedance measurement.
FIG. 8 is a block diagram illustrating another example embodiment of the method of inspecting a welding state of a battery of the present disclosure.
FIG. 9 is a block diagram illustrating a method of manufacturing a battery of the present disclosure.

### Best Mode for Carrying Out the Invention

A method of inspecting a welding state of a battery of the present disclosure includes:
a first impedance measuring step of measuring a first impedance by applying an AC current or an AC voltage in a set frequency band before an electrolyte is injected into the battery; a first Cole-Cole plot creating step of creating a first Cole-Cole plot based on the first impedance; and a first determining step of determining the welding state of the battery based on an x-intercept value on the first Cole-Cole plot.

In the first determining step of determining the welding state of the method of inspecting a welding state of a battery of the present disclosure, if the x-intercept value on the first Cole-Cole plot is greater than or equal to a first set value, the welding state of the battery may be determined to be defective.

The method of inspecting a welding state of a battery of the present disclosure may further include: after the first determining step of determining the welding state, a second impedance measuring step of measuring a second impedance by applying an AC current or an AC voltage in a set frequency band after an electrolyte is injected into the battery; a second Cole-Cole plot creating step of creating a second Cole-Cole plot based on the second impedance; and a second determining step of determining the welding state of the battery based on a minimum value on the second Cole-Cole plot.

In the second determining step of determining the welding state of the method of inspecting a welding state of a battery of the present disclosure, if a value obtained by subtracting an x-intercept value from a real part of the minimum value on the second Cole-Cole plot is greater than or equal to a second set value, the welding state of the battery may be determined to be defective.

In the first and second impedance measuring steps of the method of inspecting a welding state of a battery of the present disclosure, the first impedance and the second impedance may be measured for each frequency value of a plurality of frequency values within the set frequency band.

In the first and second impedance measuring steps of the method of inspecting a welding state of a battery of the present disclosure, the first impedance and the second impedance may be measured with a 4-wire AC impedance meter.

In the method of inspecting a welding state of a battery of the present disclosure, the battery may be provided in plurality, and in the first impedance measuring step or the second impedance measuring step, the first impedance or the second impedance may be measured by applying an AC current or an AC voltage in the set frequency band to the plurality of batteries connected in parallel.

The method of inspecting a welding state of a battery of the present disclosure includes:
a steady-state impedance measuring step of measuring a steady-state impedance by applying an AC current or an AC voltage in a set frequency band before an electrolyte is injected into a battery in a good welding state; a steady-state Cole-Cole plot creating step of creating a steady-state Cole-Cole plot based on the steady-state impedance; a test frequency extracting step of extracting a test frequency corresponding to a steady-state x-intercept value on the steady-state Cole-Cole plot; a test target battery measuring step of measuring an impedance by applying an AC current or an AC voltage at the test frequency before an electrolyte is injected into the test target battery; and a welding state determining step of determining a welding state of the test target battery based on the impedance value of the test target battery.

A method of manufacturing a battery of of the present disclosure includes:
an electrode assembly preparing step of preparing an electrode assembly by laminating a current collector and a separator, and then winding or stacking the current collector and the separator in the electrode assembly; a first welding step of first welding a tap or a current collector plate to the current collector of the electrode assembly; a second welding step of second welding a can housing or an electrode lead to the tap or the current collector plate; a first determining step of determining welding states of the first welding and the second welding by applying an AC current or an AC voltage in a set frequency band to the can housing or the electrode lead; an electrolyte injecting step of injecting an electrolyte into the electrode assembly received in a can housing or a pouch case; and a second determining step of determining welding states of the first welding and the second welding by applying an AC current or an AC voltage in a set frequency band to the can housing or the electrode lead.

The first determining step of the method of manufacturing a battery of of the present disclosure may include: a first impedance measuring step of measuring a first impedance by applying an AC current or an AC voltage in the set frequency band, a first Cole-Cole plot creating step of creating a first Cole-Cole plot based on the first impedance, and a determining step of determining the welding state of the battery to be defective if an x-intercept value on the first Cole-Cole plot is greater than or equal to a first set value.

The second determining step of the method of manufacturing a battery of of the present disclosure may include: a second impedance measuring step of measuring a second impedance by applying an AC current or an AC voltage in the set frequency band, a second Cole-Cole plot creating step of creating a second Cole-Cole plot based on the second impedance, and a determining step of determining the welding state of the battery to be defective if a value obtained by subtracting an x-intercept value from a real part of a minimum value on the second Cole-Cole plot is greater than or equal to a second set value.

### Modes for Carrying Out the Invention

Hereinafter, example embodiments according to the present disclosure will be described in detail with reference to the accompanying drawings. Here, the size or shape of components shown in the drawings may be exaggerated for clarity and convenience of explanation. In addition, terms specifically defined in consideration of the configuration and operation of the present disclosure may vary depending on the intention or custom of a user or an operator. Definitions of these terms should be made based on the context throughout this specification.

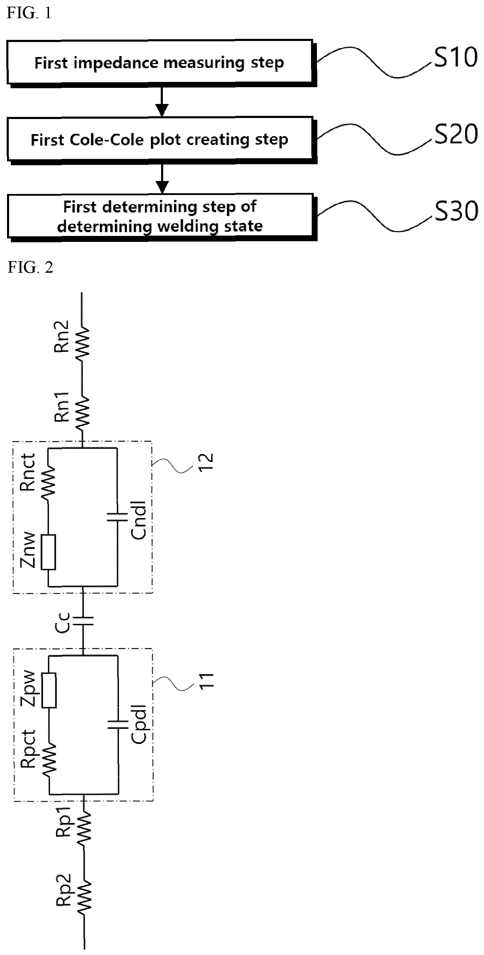

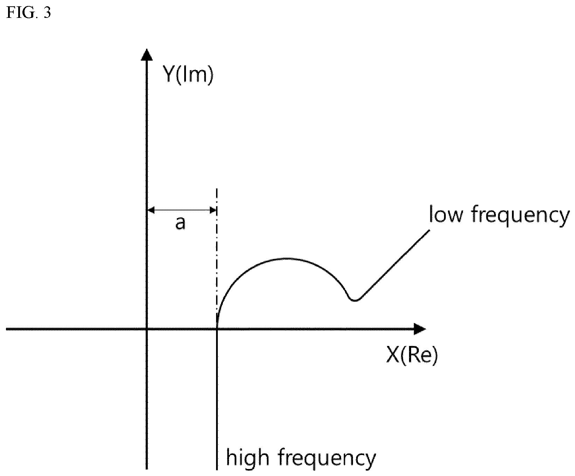

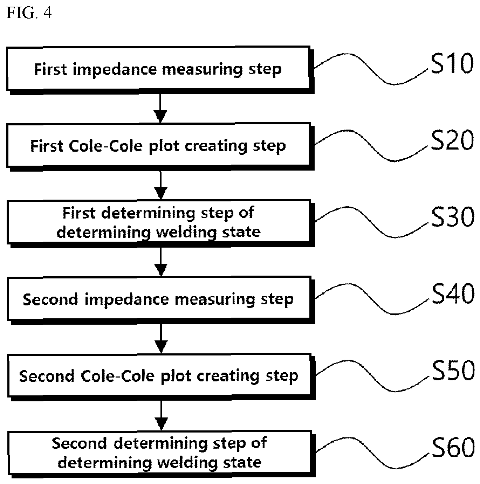

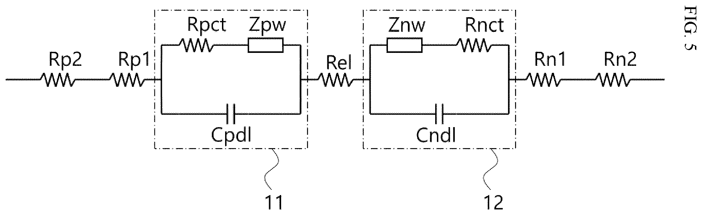

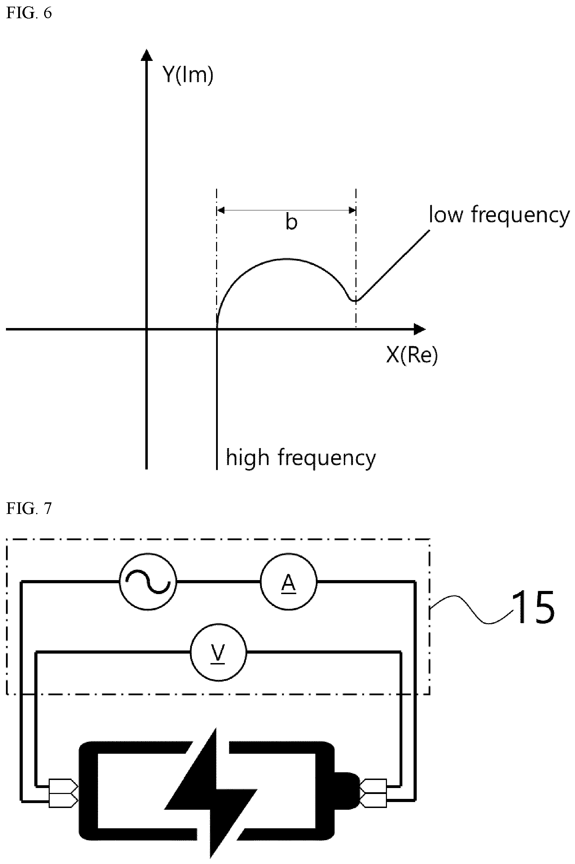

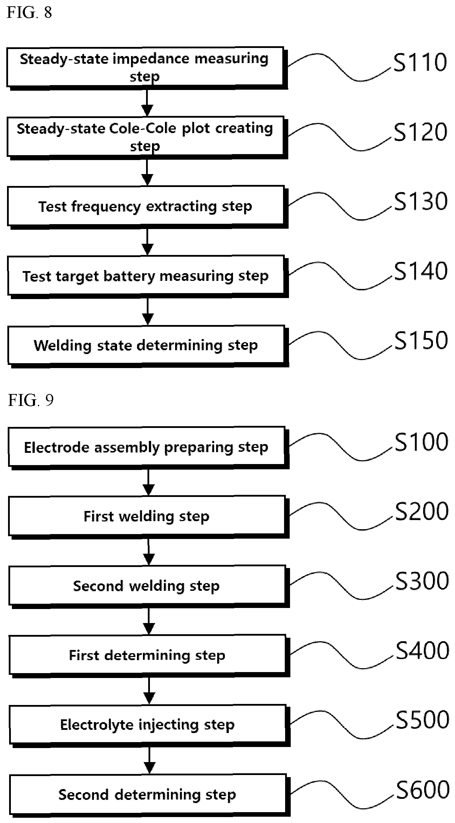

FIG. 1 is a block diagram illustrating a method of inspecting a welding state of a battery of the present disclosure. FIG. 2 is an equivalent circuit diagram illustrating a battery in a first impedance measuring step S10. FIG. 3 is a graph illustrating a first Cole-Cole plot. FIG. 4 is a block diagram illustrating another example embodiment of the method of inspecting a welding state of a battery of the present disclosure. FIG. 5 is an equivalent circuit diagram illustrating a battery in a second impedance measuring step S40. FIG. 6 is a graph illustrating a second Cole-Cole plot. FIG. 7 is a conceptual diagram illustrating a 4-wire AC impedance measurement. FIG. 8 is a block diagram illustrating another example embodiment of the method of inspecting a welding state of a battery of the present disclosure. FIG. 9 is a block diagram illustrating a method of manufacturing a battery of the present disclosure.

Hereinafter, the method of inspecting a welding state of a battery of the present disclosure will be described in detail with reference to FIGS. 1 to 8.

The method of inspecting a welding state of a battery of the present disclosure may be capable of determining a welding state of the battery simply by measuring the impedance between an anode and a cathode within a short time period without destructing the battery during the manufacture of the battery. As such, the method of inspecting a welding state of a battery of the present disclosure may be adopted in the battery production line, thereby allowing for in-line total inspection of the batteries produced.

The method of inspecting a welding state of a battery of the present disclosure may be capable of inspecting a welding state of the battery before an electrolyte is injected into the battery, thereby allowing for inspection of the welding state of the battery regardless of the injection state of the electrolyte.

The method of inspecting a welding state of a battery of the present disclosure may be applicable to any battery types (such as a cylindrical battery, a prismatic battery, a pouch-type battery, etc.) whose manufacturing processes include a welding process.

In a test target battery subject to the method of inspecting a welding state of a battery of the present disclosure, a tap or a current collector plate may be welded to a current collector of an electrode assembly, wherein the current collector and a separator are wound or stacked in the electrode assembly, and a can housing or an electrode lead may be welded to the tap or the current collector plate.

The current collector may be provided in pairs, and more specifically, may be provided as a cathode current collector and an anode current collector. The cathode current collector may be coated with a cathode active material, and the anode current collector may be coated with an anode active material. A single cathode current collector and a single anode current collector may be provided, or the cathode and anode current collectors may be provided in plurality depending on a type of the battery. The separator may be laminated between the cathode current collector and the anode current collector.

The cathode current collector, the anode current collector, and the separator may be wound or stacked in a laminated state to form an electrode assembly. For example, an electrode assembly may be formed for a cylindrical battery or a prismatic battery by winding a cathode current collector, an anode current collector, and a separator while may be stacked to form an electrode assembly for a pouch-type battery.

The tap or the current collector plate may be a conductive material, which serves as an intermediate bridge electrically connecting the can housing or the electrode lead to the anode current collector or the cathode current collector. The taps or current collector plates may also be provided in pairs, and may be welded for the cathode current collector and the anode current collector, respectively.

The can housing or the electrode leads may be connected to an electrode terminal of an external electric device. In a cylindrical battery or a prismatic battery, taps or current collector plates corresponding to the cathode and the anode are each welded to the can housing and the electrode lead fixed to the can housing, and in the case of a pouch-type battery, the electrode lead may be provided for the cathode and the anode, respectively.

Welding between the current collector and the tap or the current collector plates as well as welding between the tap or the current collector plate and the can housing or the electrode lead may be laser welding, ultrasonic welding, resistance welding, or the like.

As shown in FIG. 1, the method of inspecting a welding state of a battery of the present disclosure includes:
a first impedance measuring step S10 of measuring a first impedance by applying an AC current or an AC voltage in a set frequency band before an electrolyte is injected into the battery;
a first Cole-Cole plot creating step S20 of creating a first Cole-Cole plot based on the first impedance; and
a first determining step S30 of determining the welding state of the battery based on an x-intercept value on the first Cole-Cole plot.

In the first impedance measuring step S10, the first impedance may be measured by electrically connecting to the can housing or the electrode lead corresponding to the cathode and the anode. That is, the impedance value of the battery itself without any injected electrolyte may be the first impedance.

In the first impedance measuring step S10, the first impedance may be measured for each frequency value of a plurality of frequency values within the set frequency band. A set of impedance values measured for a plurality of consecutive frequency values may be the first impedance. In other words, the first impedance may include a plurality of impedance values.

In the first Cole-Cole plot creating step S20, the first Cole-Cole plot may be a graph where the first impedance values are plotted on a complex number plane. The first Cole-Cole plot may be created on a two-dimensional graph where the x-axis represents real part values and the y-axis represents imaginary part values. A Cole-Cole plot may be a graph where a plurality of impedance values measured for a plurality of frequency values are plotted on a complex plane.

Assuming that the first welding refers to the welding between the current collector of the electrode assembly and the tap or the current collector plates, and the second welding refers to the welding between the tap or the current collector plates and the can housing or the electrode lead, as shown in FIG. 2, an equivalent circuit of the battery prior to the injection of the electrolyte may be a circuit in which an anode equivalent circuit 11 and a cathode equivalent circuit 12 of the electrode assembly, an anode resistance Rp1 and a cathode resistance Rn1 by the first welding, and an anode resistance Rp2 and a cathode resistance Rn2 by the second welding are connected in series. In this case, the equivalent circuit of the battery prior to the injection of the electrolyte may be a circuit in which a capacitor Cc is connected in series between the anode equivalent circuit 11 and the cathode equivalent circuit 12.

Accordingly, as shown in FIG. 3, the anode resistance Rp1 and the cathode resistance Rn1 by the first welding, and the second anode resistance Rp2 and the cathode resistance Rn2 by the second welding may correspond to a value of a, i.e., an x-intercept value on the first Cole-Cole plot, which is a Cole-Cole plot for the battery prior to the injection of the electrolyte.

In the anode equivalent circuit 11 of the electrode assembly, Rpct is an anode current collector resistance, Zpw is an anode Warburg impedance, and Cpdl is a capacitance between the anode current collector and the anode active material. In the cathode equivalent circuit 12 of the electrode assembly, Rnct is a cathode current collector resistance, Znw is a cathode Warburg impedance, and Cndl is a capacitance between the cathode current collector and the cathode active material.

In the first determining step S30 of determining the welding state, if the x-intercept value a on the first Cole-Cole plot is greater than or equal to a first set value, the welding state of the battery may be determined to be defective. The first set value may be calculated as a theoretical value in view of the material included in the battery, or may be configured in view of an x-intercept value on the Cole-Cole plot obtained from taking measurements on a steady-state battery in a good welding state without any injected electrolyte. For example, the first set value may be the x-intercept value of a Cole-Cole plot for a steady-state battery. It is possible to determine a value greater than or equal to the first set value to be a defective welding state because the x-intercept value is increased if the welding is defective.

As shown in FIG. 4, the method of inspecting a welding state of a battery of the present disclosure may further include:
after the first determining step S30 of determining the welding state, a second impedance measuring step S40 of measuring a second impedance by applying an AC current or an AC voltage in a set frequency band after an electrolyte is injected into the battery;
a second Cole-Cole plot creating step S50 of creating a second Cole-Cole plot based on the second impedance; and
a second determining step S60 of determining the welding state of the battery based on a minimum value on the second Cole-Cole plot.

According to the method of inspecting a welding state of a battery of the present disclosure, it is possible to more accurately detect defective welding by independently inspecting a welding state of each battery for both before and after the injection of the electrolyte.

In the second impedance measuring step S40, the second impedance may be measured by electrically connecting to the can housing or the electrode lead corresponding to the cathode and the anode. That is, the impedance value of the battery itself with the injected electrolyte may be the second impedance value.

In the second impedance measuring step S40, the second impedance may be measured for each frequency value of a plurality of frequency values within the set frequency band. A set of impedance values measured for a plurality of consecutive frequency values may be the second impedance. That is, the second impedance may include a plurality of impedance values.

As shown in FIG. 5, an equivalent circuit of the battery into which an electrolyte is injected may also be a circuit in which an anode equivalent circuit 11 and a cathode equivalent circuit 12 of the electrode assembly, an anode resistance Rp1 and a cathode resistance Rn1 by the first welding, and an anode resistance Rp2 and a cathode resistor Rn2 by the second welding are connected in series. In this case, the equivalent circuit of the battery into which the electrolyte is injected may be a circuit in which a resistor Rel is connected in series between the anode equivalent circuit 11 and the cathode equivalent circuit 12 of the electrode assembly.

Therefore, as shown in FIG. 6, after the electrolyte is injected, the anode resistance Rp1 and the cathode resistance Rn1 by the first welding, and the anode resistance Rp2 and the cathode resistance Rn2 by the second welding may correspond to a value of b obtained from subtracting an x-intercept value from a real part of a minimum on the second Cole-Cole plot, which is a Cole-Cole plot for the battery after the injection of the electrolyte.

Therefore, in the second determining step S60 of determining the welding state, if the value b obtained by subtracting the x-intercept value from the real part of the minimum value on the second Cole-Cole plot is greater than or equal to a second set value, the welding state of the battery may be determined to be defective. The second set value may be calculated as a theoretical value in view of the material included in the battery, or may be configured in view of an x-intercept value on the Cole-Cole plot obtained by taking measurements on a steady-state battery with the injected electrolyte in a good welding state. For example, the second set value may be a value obtained from subtracting the x-intercept value from the minimum value on the Cole-Cole plot. It is possible to determine a value greater than or equal to the second set value to be a defective welding state because the value obtained from subtracting the x-intercept value from the real part of the minimum value on the Cole-Cole plot is increased if the welding is defective.

As shown in FIG. 7, in the first impedance measuring step S10 and the second impedance measuring step S40, the first impedance and the second impedance may be measured with a 4-wire AC impedance meter 15. The 4-wire AC impedance meter 15 may be configured to accurately measure an impedance value of 1 Ω or less by minimizing the influence of wiring resistance or contact resistance.

In the 4-wire AC impedance meter 15, the anode probe and the cathode probe may independently include a terminal connected to an ammeter and a terminal connected to a voltmeter, respectively.

In the first impedance measuring step S10 or the second impedance measuring step S40, the first impedance or the second impedance may be measured by applying an AC current or an AC voltage in a set frequency band to the plurality of batteries connected in parallel. The plurality of batteries may be grouped by a number of batteries belonging to one battery inspection unit, and a plurality of batteries in each of these groups may be connected in parallel to measure a corresponding impedance at once. It is possible to determine the welding state on a group-by-group basis, and a plurality of batteries in defective groups may be remeasured individually.

As shown in FIG. 8, in another example embodiment, a method of inspecting a welding state of a battery of the present disclosure includes:
a steady-state impedance measuring step S110 of measuring a steady-state impedance by applying an AC current or an AC voltage in a set frequency band before an electrolyte is injected into a battery in a good welding state;
a steady-state Cole-Cole plot creating step S120 of creating a steady-state Cole-Cole plot based on the steady-state impedance;
a test frequency extracting step S130 of extracting a test frequency corresponding to an x-intercept value on the steady-state Cole-Cole plot;
a test target battery measuring step S140 of measuring an impedance by applying an AC current or an AC voltage at the test frequency before an electrolyte is injected into the test target battery; and
a welding state determining step S150 of determining a welding state of the test target battery based on the impedance value of the test target battery.

In the steady-state impedance measuring step S110, the battery in a good welding state may be a battery whose welding state was identified as a steady-state. For example, the steady-state impedance value may be selected from an impedance value of a battery in a steady welding state by measuring impedance values for a plurality of unknown batteries and then determining each welding state by other types of methods for inspecting a welding state such as destructive inspection by sampling welding sites.

In the steady-state impedance measuring step S110, the steady-state impedance value may be obtained by measuring impedance values for a plurality of consecutive frequency values.

In the test frequency extracting step S130, a frequency value measured when the imaginary part is zero may be extracted as the value of the test frequency.

In the test target battery measuring step S140, the impedance of the test target battery may be measured at the test frequency, which is a constant frequency value. By inspecting a battery with a single frequency value rather than a frequency band, it is possible to minimize the time required for impedance measurement, and even in the case of a mass battery production line, it is possible to minimize any time delay associated with the battery manufacture.

In the determining step S150 of the welding state, the welding state may be determined to be defective if the impedance value of the test target battery is greater than a reference value. The reference value may be set in view of the x-intercept value on the steady-state Cole-Cole plot created in the steady-state Cole-Cole plot creating step S120.

As shown in FIG. 9, a method of manufacturing a battery of the present disclosure includes:
an electrode assembly preparing step S 100 of preparing an electrode assembly by laminating a current collector and a separator and then winding or stacking the current collector and the separator;
a first welding step S200 of first welding a tap or a current collector plate to the current collector of the electrode assembly;
a second welding step S300 of second welding a can housing or an electrode lead to the tap or the current collector plate;
a first determining step S400 of determining welding states of the first welding and the second welding by applying an AC current or an AC voltage in a set frequency band to the can housing or the electrode lead;
an electrolyte injecting step S500 of injecting an electrolyte into the electrode assembly received in a can housing or a pouch case; and
a second determining step S600 of determining welding states of the first welding and the second welding by applying an AC current or an AC voltage in a set frequency band to the can housing or the electrode lead.

The first determining step S400 may include a first impedance measuring step of measuring a first impedance by applying an AC current or an AC voltage in a set frequency band, first Cole-Cole plot creating step of creating a first Cole-Cole plot based on the first impedance, and a determining step of determining the welding state of the battery to be defective if an x-intercept value on the first Cole-Cole plot is greater than or equal to a first set value.

In another example embodiment, the first determining step S400 may include an impedance measuring step of measuring an impedance by applying an AC current or an AC voltage at a test frequency, and a determining step of determining the welding state of the battery to be defective if a real part of the measured impedance is greater than or equal to a reference value.

The second determining step S600 may include a second impedance measuring step of measuring a second impedance by applying an AC current or an AC voltage in a set frequency band, a first Cole-Cole plot creating step of creating a first Cole-Cole plot based on the second impedance, and a determining step of determining the welding state of the battery to be defective if a value obtained by subtracting an x-intercept value from a real part of a minimum value on the second Cole-Cole plot is greater than or equal to a second set value.

The invention is defined by the appended claims.

### Industrial Applicability

According to a method of inspecting a welding state of a battery of the present disclosure, it is possible to perform in-line total inspection, thereby improving the quality of battery production and removing defective batteries in advance.

According to a method of inspecting a welding state of a battery of the present disclosure, it is possible to identify welding qualities within a short time period.

According to a method of inspecting a welding state of a battery of the present disclosure, it is possible to determine a welding state of the battery simply by measuring the impedance between an anode and a cathode within a short time period without destructing the battery during the manufacture of the battery. As such, the method of inspecting a welding state of a battery of the present disclosure may be adopted in the battery production line, thereby allowing for in-line total inspection of the batteries produced.

According to a method of inspecting a welding state of a battery of the present disclosure, it is possible to inspect the welding state of the battery before an electrolyte is injected into the battery, thereby allowing for inspection of the welding state of the battery regardless of the injection state of the electrolyte.

## Claims

1. A method of inspecting a welding state of a battery, wherein a tap or a current collector plate is welded to a current collector of an electrode assembly, the electrode assembly having the current collector and a separator wound or stacked therein, and a can housing or an electrode lead is welded to the tap or the current collector plate, the method comprising:
a first impedance measuring step (S10) of measuring a first impedance by applying an AC current or an AC voltage in a set frequency band before an electrolyte is injected into the battery;
a first Cole-Cole plot creating step (S20) of creating a first Cole-Cole plot based on the first impedance; and
a first determining step of determining the welding state of the battery (S30) based on an x-intercept value on the first Cole-Cole plot.

2. The method of claim 1, wherein in the first determining step of determining the welding state, the welding state of the battery is determined to be defective if the x-intercept value on the first Cole-Cole plot is greater than or equal to a first set value.

3. The method of claim 1, further comprising:
after the first determining step of determining the welding state,
a second impedance measuring step of measuring a second impedance by applying an AC current or an AC voltage in a set frequency band after the electrolyte is injected into the battery;
a second Cole-Cole plot creating step of creating a second Cole-Cole plot based on the second impedance; and
a second determining step of determining the welding state of the battery based on a minimum value on the second Cole-Cole plot.

4. The method of claim 3, wherein, in the second determining step of determining the welding state,
the welding state of the battery is determined to be defective if a value obtained by subtracting an x-intercept value from a real part of the minimum value on the second Cole-Cole plot is greater than or equal to a second set value.

5. The method of claim 3, wherein, in the first impedance measuring step and the second impedance measuring step,
the first impedance and the second impedance are measured for each frequency value of a plurality of frequency values within the set frequency band.

6. The method of claim 3, wherein, in the first impedance measuring step and the second impedance measuring step,
the first impedance and the second impedance are measured with a 4-wire AC impedance meter.

7. The method of claim 3, wherein a plurality of the batteries are provided, and
wherein, in the first impedance measuring step or the second impedance measuring step,
the first impedance or the second impedance is measured by applying an AC current or an AC voltage in the set frequency band to the plurality of batteries connected in parallel.

8. A method of inspecting a welding state of a battery, comprising:
a steady-state impedance measuring step (S110) of measuring a steady-state impedance by applying an AC current or an AC voltage in a set frequency band before an electrolyte is injected into the battery in a good welding state;
a steady-state Cole-Cole plot creating step (S120) of creating a steady-state Cole-Cole plot based on the steady-state impedance;
a test frequency extracting step (S130) of extracting a test frequency corresponding to a steady-state x-intercept value on the steady-state Cole-Cole plot;
a test target battery measuring step (S140) of measuring an impedance by applying an AC current or an AC voltage at the test frequency before an electrolyte is injected into a test target battery; and
a welding state determining step (S150) of determining the welding state of the test target battery based on an impedance value of the test target battery.

9. A method of manufacturing a battery, the method comprising:
an electrode assembly preparing step (S100) of preparing an electrode assembly by laminating a current collector and a separator, and then winding or stacking the current collector and the separator in the electrode assembly;
a first welding step (S200) of first welding a tap or a current collector plate to the current collector of the electrode assembly;
a second welding step (S300) of second welding a can housing or an electrode lead to the tap or the current collector plate;
a first determining step (S400) of determining welding states of the first welding and the second welding by applying an AC current or an AC voltage in a set frequency band to the can housing or the electrode lead;
an electrolyte injecting step (S500) of injecting an electrolyte into the electrode assembly received in a can housing or a pouch case; and
a second determining step (S600) of determining welding states of the first welding and the second welding by applying an AC current or an AC voltage in a set frequency band to the can housing or the electrode lead.

10. The method of claim 9, wherein the first determining step comprises:
measuring a first impedance by applying an AC current or an AC voltage in a set frequency band;
creating a first Cole-Cole plot based on the first impedance; and
determining the welding state of the battery to be defective if an x-intercept value on the first Cole-Cole plot is greater than or equal to a first set value.

11. The method of claim 9, wherein the second determining step comprises:
measuring a second impedance by applying an AC current or an AC voltage in a set frequency band;
creating a second Cole-Cole plot based on the second impedance; and
determining the welding state of the battery to be defective if a value obtained by subtracting an x-intercept value from a real part of a minimum value on the second Cole-Cole plot is greater than or equal to a second set value.

## Patentansprüche

1. Verfahren zum Prüfen eines Schweißzustands einer Batterie, wobei ein Abgriff oder eine Stromkollektorplatte an einen Stromkollektor einer Elektrodenanordnung geschweißt wird, wobei die Elektrodenanordnung den Stromkollektor und einen Separator, der darin gewickelt oder gestapelt ist, aufweist, und ein Dosengehäuse oder eine Elektrodenleitung an den Abgriff oder die Stromkollektorplatte geschweißt wird, wobei das Verfahren umfasst:
einen ersten Impedanzmessschritt (S10) zum Messen einer ersten Impedanz durch Anlegen eines Wechselstroms oder einer Wechselspannung in einem eingestellten Frequenzband, bevor ein Elektrolyt in die Batterie injiziert wird;
einen ersten Cole-Cole-Diagramm-Erzeugungsschritt (S20) zum Erzeugen eines ersten Cole-Cole-Diagramms basierend auf der ersten Impedanz; und
einen ersten Bestimmungsschritt zum Bestimmen des Schweißzustands der Batterie (S30) basierend auf einem x-Intercept-Wert auf dem ersten Cole-Cole-Diagramm.

2. Verfahren nach Anspruch 1, wobei in dem ersten Bestimmungsschritt zum Bestimmen des Schweißzustands bestimmt wird, dass der Schweißzustand der Batterie fehlerhaft ist, wenn der x-Intercept-Wert auf dem ersten Cole-Cole-Diagramm größer oder gleich einem ersten eingestellten Wert ist.

3. Verfahren nach Anspruch 1, ferner umfassend:
nach dem ersten Bestimmungsschritt zum Bestimmen des Schweißzustands,
einen zweiten Impedanzmessschritt zum Messen einer zweiten Impedanz durch Anlegen eines Wechselstroms oder einer Wechselspannung in einem eingestellten Frequenzband, nachdem der Elektrolyt in die Batterie injiziert wird;
einen zweiten Cole-Cole-Diagramm-Erzeugungsschritt zum Erzeugen eines zweiten Cole-Cole-Diagramms basierend auf der zweiten Impedanz; und
einen zweiten Bestimmungsschritt zum Bestimmen des Schweißzustands der Batterie basierend auf einem Minimalwert auf dem zweiten Cole-Cole-Diagramm.

4. Verfahren nach Anspruch 3, wobei in dem zweiten Bestimmungsschritt zum Bestimmen des Schweißzustands,
bestimmt wird, dass der Schweißzustand der Batterie fehlerhaft ist, wenn ein Wert, der durch Subtrahieren eines x-Intercept-Werts von einem Realteil des Minimalwerts auf dem zweiten Cole-Cole-Diagramm erhalten wird, größer oder gleich einem zweiten eingestellten Wert ist.

5. Verfahren nach Anspruch 3, wobei in dem ersten Impedanzmessschritt und dem zweiten Impedanzmessschritt,
die erste Impedanz und die zweite Impedanz für jeden Frequenzwert einer Mehrzahl von Frequenzwerten innerhalb des eingestellten Frequenzbands gemessen werden.

6. Verfahren nach Anspruch 3, wobei in dem ersten Impedanzmessschritt und dem zweiten Impedanzmessschritt,
die erste Impedanz und die zweite Impedanz mit einem 4-Draht-Wechselstromimpedanzmessgerät gemessen werden.

7. Verfahren nach Anspruch 3, wobei eine Mehrzahl der Batterien bereitgestellt wird, und
wobei in dem ersten Impedanzmessschritt oder dem zweiten Impedanzmessschritt,
die erste Impedanz oder die zweite Impedanz durch Anlegen eines Wechselstroms oder einer Wechselspannung in dem eingestellten Frequenzband an die Mehrzahl von Batterien, die parallel geschaltet sind, gemessen wird.

8. Verfahren zum Prüfen eines Schweißzustands einer Batterie, umfassend:
einen stationären Impedanzmessschritt (S110) zum Messen einer stationären Impedanz durch Anlegen eines Wechselstroms oder einer Wechselspannung in einem eingestellten Frequenzband, bevor ein Elektrolyt in die Batterie in einem guten Schweißzustand injiziert wird;
einen stationären Cole-Cole-Diagramm-Erzeugungsschritt (S120) zum Erzeugen eines stationären Cole-Cole-Diagramms basierend auf der stationären Impedanz;
einen Testfrequenzextraktionsschritt (S130) zum Extrahieren einer Testfrequenz, die einem stationären x-Intercept-Wert auf dem stationären Cole-Cole-Diagramm entspricht;
einen Testzielbatterie-Messschritt (S140) zum Messen einer Impedanz durch Anlegen eines Wechselstroms oder einer Wechselspannung bei der Testfrequenz, bevor ein Elektrolyt in eine Testzielbatterie injiziert wird; und
einen Schweißzustandsbestimmungsschritt (S150) zum Bestimmen des Schweißzustands der Testzielbatterie basierend auf einem Impedanzwert der Testzielbatterie.

9. Verfahren zum Herstellen einer Batterie, wobei das Verfahren umfasst:
einen Elektrodenanordnungsvorbereitungsschritt (S100) zum Vorbereiten einer Elektrodenanordnung durch Laminieren eines Stromkollektors und eines Separators und dann Wickeln oder Stapeln des Stromkollektors und des Separators in der Elektrodenanordnung;
einen ersten Schweißschritt (S200) zum ersten Schweißen eines Abgriffs oder einer Stromkollektorplatte an den Stromkollektor der Elektrodenanordnung;
einen zweiten Schweißschritt (S300) zum zweiten Schweißen eines Dosengehäuses oder einer Elektrodenleitung an den Abgriff oder die Stromkollektorplatte;
einen ersten Bestimmungsschritt (S400) zum Bestimmen von Schweißzuständen des ersten Schweißens und des zweiten Schweißens durch Anlegen eines Wechselstroms oder einer Wechselspannung in einem eingestellten Frequenzband an das Dosengehäuse oder die Elektrodenleitung;
einen Elektrolytinjektionsschritt (S500) zum Injizieren eines Elektrolyts in die Elektrodenanordnung, die in einem Dosengehäuse oder einem Beutelgehäuse aufgenommen ist; und
einen zweiten Bestimmungsschritt (S600) zum Bestimmen von Schweißzuständen des ersten Schweißens und des zweiten Schweißens durch Anlegen eines Wechselstroms oder einer Wechselspannung in einem eingestellten Frequenzband an das Dosengehäuse oder die Elektrodenleitung.

10. Verfahren nach Anspruch 9, wobei der erste Bestimmungsschritt umfasst:
Messen einer ersten Impedanz durch Anlegen eines Wechselstroms oder einer Wechselspannung in einem eingestellten Frequenzband;
Erzeugen eines ersten Cole-Cole-Diagramms basierend auf der ersten Impedanz; und
Bestimmen, dass der Schweißzustand der Batterie fehlerhaft ist, wenn ein x-Intercept-Wert auf dem ersten Cole-Cole-Diagramm größer oder gleich einem ersten eingestellten Wert ist.

11. Verfahren nach Anspruch 9, wobei der zweite Bestimmungsschritt umfasst:
Messen einer zweiten Impedanz durch Anlegen eines Wechselstroms oder einer Wechselspannung in einem eingestellten Frequenzband;
Erzeugen eines zweiten Cole-Cole-Diagramms basierend auf der zweiten Impedanz; und
Bestimmen, dass der Schweißzustand der Batterie fehlerhaft ist, wenn ein Wert, der durch Subtrahieren eines x-Intercept-Werts von einem Realteil eines Minimalwerts auf dem zweiten Cole-Cole-Diagramm erhalten wird, größer oder gleich einem zweiten eingestellten Wert ist.

## Revendications

1. Procédé d'inspection de l'état de soudage d'une batterie, une prise ou une plaque collectrice de courant étant soudée sur un collecteur de courant d'un ensemble d'électrodes, le collecteur de courant et un séparateur étant enroulés ou empilés dans l'ensemble d'électrodes, et un boîtier tronconique ou un conducteur d'électrode étant soudé sur la prise ou la plaque collectrice de courant, le procédé comprenant :
une étape de mesure de la première impédance (S10) comportant la mesure d'une première impédance par l'application d'un courant CA ou d'une tension CA dans une bande de fréquence définie préalablement à l'injection d'un électrolyte dans la batterie ;
une étape de création d'un premier tracé de Cole-Cole (S20) comportant la création d'un premier tracé de Cole-Cole d'après la première impédance ; et
une première étape de détermination comportant la détermination de l'état de soudage de la batterie (S30) d'après une abscisse à l'origine sur le premier tracé de Cole-Cole.

2. Procédé selon la revendication 1, dans lequel, dans la première étape de détermination comportant la détermination de l'état de soudage, l'état de soudage de la batterie est établi comme étant défectueux lorsque l'abscisse à l'origine sur le premier tracé de Cole-Cole est supérieure ou égale à une première valeur nominale.

3. Procédé selon la revendication 1, comprenant en outre :
après la première étape de détermination comportant la détermination de l'état de soudage,
une étape de mesure de la deuxième impédance comportant la mesure d'une deuxième impédance par l'application d'un courant CA ou d'une tension CA dans une bande de fréquence définie après l'injection de l'électrolyte dans la batterie ;
une étape de création d'un deuxième tracé de Cole-Cole comportant la création d'un deuxième tracé de Cole-Cole d'après la deuxième impédance ; et
une deuxième étape de détermination comportant la détermination de l'état de soudage de la batterie d'après une valeur minimum sur le deuxième tracé de Cole-Cole.

4. Procédé selon la revendication 3, dans lequel, dans la deuxième étape de détermination comportant la détermination de l'état de soudage,
l'état de soudage de la batterie est déterminé comme étant défectueux lorsqu'une valeur obtenue en soustrayant une abscisse à l'origine d'une partie réelle de la valeur minimale sur le deuxième tracé de Cole-Cole est supérieure ou égale à une deuxième valeur nominale.

5. Procédé selon la revendication 3, dans lequel, au cours de l'étape de mesure de la première impédance et de l'étape de mesure de la deuxième impédance,
la première impédance et la deuxième impédance sont mesurées pour chaque valeur de la fréquence d'une pluralité de valeurs de la fréquence au sein de la bande de fréquence définie.

6. Procédé selon la revendication 3, dans lequel, au cours de l'étape de mesure de la première impédance et de l'étape de mesure de la deuxième impédance,
la première impédance et la deuxième impédance sont mesurées avec un impédancemètre CA 4 fils.

7. Procédé selon la revendication 3, comportant l'agencement d'une pluralité de batteries, et,
au cours de l'étape de mesure de la première impédance et de l'étape de mesure de la deuxième impédance
la première impédance ou la deuxième impédance est mesurée en appliquant un courant CA ou une tension CA dans la bande de fréquence définie sur la pluralité de batteries connectées en parallèle.

8. Procédé d'inspection de l'état de soudage d'une batterie, comprenant:
une étape de mesure de l'impédance en régime permanent (S110) comportant la mesure d'une impédance en régime permanent par l'application d'un courant CA ou d'une tension CA dans une bande de fréquence définie préalablement à l'injection d'un électrolyte dans la batterie en bon état de soudage;
une étape de création d'un tracé de Cole-Cole en régime permanent (S120) comportant la création d'un tracé de Cole-Cole en régime permanent d'après l'impédance en régime permanent;
une étape d'extraction d'une fréquence d'essai (S130) comportant l'extraction d'une fréquence d'essai correspondant à une valeur d'abscisse à l'origine en régime permanent sur le tracé de Cole-Cole en régime permanent;
une étape de mesure de la batterie cible d'essai (S140) comportant la mesure d'une impédance par l'application d'un courant CA ou d'une tension CA à la fréquence d'essai préalablement à l'injection d'un électrolyte dans la batterie cible d'essai ; et
une étape de détermination de l'état de soudage (S150) comportant la détermination de l'état de soudage de la batterie cible d'essai d'après une valeur d'impédance de la batterie cible d'essai.

9. Procédé de fabrication d'une batterie, le procédé comprenant :
une étape de préparation d'un ensemble d'électrodes (S100) comportant la préparation d'un ensemble d'électrodes en stratifiant un collecteur de courant et un séparateur, puis en enroulant ou en empilant le collecteur de courant et le séparateur dans l'ensemble d'électrodes ;
une première étape de soudage (S200) comportant un premier soudage d'une prise ou d'une plaque collectrice de courant sur le collecteur de courant de l'ensemble d'électrodes ;
une deuxième étape de soudage (S300) comportant un deuxième soudage d'un boîtier tronconique ou d'un conducteur d'électrode sur la prise ou sur la plaque collectrice de courant ;
une première étape de détermination (S400) comportant la détermination d'états de soudage du premier soudage et du deuxième soudage par l'application d'un courant CA ou d'une tension CA, dans une bande de fréquence définie, sur le boîtier tronconique ou le conducteur d'électrode ;
une étape d'injection d'électrolyte (S500) comportant l'injection d'un électrolyte dans l'ensemble d'électrodes reçu dans un boîtier tronconique ou un étui ; et
une deuxième étape de détermination (S600) comportant la détermination d'états de soudage du premier soudage et du deuxième soudage par l'application d'un courant CA ou d'une tension CA dans une bande de fréquence définie, sur le boîtier tronconique ou le conducteur d'électrode.

10. Procédé selon la revendication 9, la première étape de détermination comprenant :
la mesure d'une première impédance par l'application d'un courant CA ou d'une tension CA dans une bande de fréquence définie ;
la création d'un premier tracé de Cole-Cole d'après la première impédance ; et
la détermination de l'état de soudage de la batterie qui est défectueux lorsqu'une abscisse à l'origine sur le premier tracé de Cole-Cole est supérieure ou égale à une première valeur définie.

11. Procédé selon la revendication 9, la deuxième étape de détermination comprenant :
la mesure d'une deuxième impédance par l'application d'un courant CA ou d'une tension CA dans une bande de fréquence définie ;
la création d'un deuxième tracé de Cole-Cole d'après la deuxième impédance ; et
la détermination de l'état de soudage de la batterie qui est défectueux lorsqu'une valeur obtenue en soustrayant une abscisse à l'origine d'une partie réelle d'une valeur minimale sur le deuxième tracé de Cole-Cole est supérieure ou égale à une deuxième valeur nominale.
